Europäisches Patentamt

European Patent Office

Office européen des brevets

(19)

(11) Publication number: **0 163 639**
**B1**

# EUROPEAN PATENT SPECIFICATION

(12)

(45) Date of publication of patent specification: **24.08.88**

(51) Int. Cl.⁴: **E 04 B 1/92** // E04C2/54

(21) Application number: **84900415.5**

(22) Date of filing: **30.12.83**

(86) International application number:
**PCT/SE83/00486**

(87) International publication number:
**WO 84/02729 19.07.84 Gazette 84/17**

(54) ARRANGEMENT FOR RESTRICTING THE TRANSMISSION OF ELECTROMAGNETIC RADIATION.

(30) Priority: **04.01.83 SE 8300025**

(43) Date of publication of application:
**11.12.85 Bulletin 85/50**

(45) Publication of the grant of the patent:
**24.08.88 Bulletin 88/34**

(84) Designated Contracting States:
**AT BE CH DE FR GB LI NL SE**

(56) References cited:
**DE-B-1 074 233**
**DE-B-1 082 386**
**DE-B-1 158 015**
**DE-B-1 509 721**
**DE-C- 809 250**
**DE-C- 824 249**
**DE-C-1 409 994**
**US-A-2 934 801**

(73) Proprietor: **BARRIER HB**
**Norra Traneredvägen 9**
**S-421 77 Västra Frölunda (SE)**

(72) Inventor: **KARLSSON, Jan**
**Kung Sverres gata 32**
**S-417 28 Göteborg (SE)**
Inventor: **FASTH, Ingemar**
**Ovrelidsgatan 21**
**S-422 47 Hisings-Backa (SE)**

(74) Representative: **Hagelberg, Anders Torvald**
**Sverker et al**
**Albihn West AB Stora Nygatan 15**
**S-411 08 Göteborg (SE)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

# Description

The present invention relates to an arrangement for restricting the transmission of electromagnetic radiation such as thermal radiation by absorption. The arrangement can be executed for this purpose in the form of an insulating element intended to insulate against such radiation. A particularly suitable area of application for the invention is in insulating window elements.

The problem of insulating against heat or cold is normally solved at the present time by the application of porous materials, that is to say materials containing a high proportion of air, said material basically serving to prevent air currents from arising. What this means in practice is that the exchange of heat through convection and conduction is reduced. A third method by which heat is transferred is through radiation. The wavelength of the radiation will depend on the temperature of the source; i.e. the higher the temperature the shorter the wavelength. For example, the surface temperature of the sun is about 6000°C, giving a radiation maximum at a wavelength of 0.6 micrometers. At more normal temperatures from about 700°C downwards, the radiation maximum will be situated between 2 and 10 micrometers, this being the so-called long-wave thermal radiation or infra-red radiation.

Insulation against radiation can, in itself, be provided with the help of porous materials because the radiation, when it meets the screening insulation element, will be converted into heat as the result of the agitation of the molecules in the material. It is also interesting, however, to be able to influence the radiation directly without permitting it to be transformed mainly into heat. This can be achieved by causing it to be reflected from, for example, metal foils. Such reflection is a commonly used method of insulation against radiation in the thermal field in transparent elements such as windows. An insulating window of this type is known from the DE—B—1 082 386.

In the mentioned reference is suggested, that a gas with high restriction of the transfer of heat is enclosed in the spaces between the glass panes of the insulating window. Mentioned are $CCl_2F_2$ and $CO_2$. These gases will, however, have a very low influence on the radiation of heat as their absorbation bands will cover only a smaller part of the wave band in which the heat is transferred, 2—25 micrometers with the maximum between 2 and 10 micrometers. In fact, there is no gas known, which will cover a substantial part of said wave band and therefore a single gas or a restricted number of gases in a mixture will not restrict the radiation of heat by absorption to a substantial part.

A disadvantage associated with the use of metals as reflectors for radiation is the fact that they are excellent thermal conductors as a general rule, this being something which, to a certain extent, will reduce their ability to prevent heat transfer. A second, and perhaps more serious disadvantage is that metallic coatings, even when they are very thin and transparent, will affect all wavelengths, with the result that the passage of radiation of shorter wavelengths is also reduced. What this means in the case of applications in windows is that the solar radiation will be reduced in such a way that the result will be a reduced influx of light and reduced short-wave thermal irradiation.

Instead of utilizing metal coatings, use is made in accordance with the invention of one or more layers of a selection of gases contained between leak-proof walls, said gases being not only poor thermal conductors, but also excellent absorbers of radiation and emitters of the absorbed electromagnetic radiation and so selected that their absorption bands are completing each other to cover a substantial part of said wave band in which heat is transferred by radiation.

As will be shown below, the use of such layers of gases is able to permit both the containment of electromagnetic radiation by absorption and the reflection of same by emission. It is possible in this way to produce an arrangement which not only possesses low thermal conductivity, but also minimizes any convection currents and also possesses a high reflective capacity against thermal radiation or other forms of electromagnetic radiation. The application of the invention in transparent elements such as windows, which would appear to be an important application, enables an excellent heat-insulating capacity to be achieved without the visible light which passes through the element being affected in the same was as it is when metal coatings are used.

The invention is described below with reference to the accompanying drawings. Figure 1 shows a section through a hermetically sealed window insert; and Figures 2 and 3 show in diagrammatic form different embodiments of the invention with regard to the desired radiation absorption.

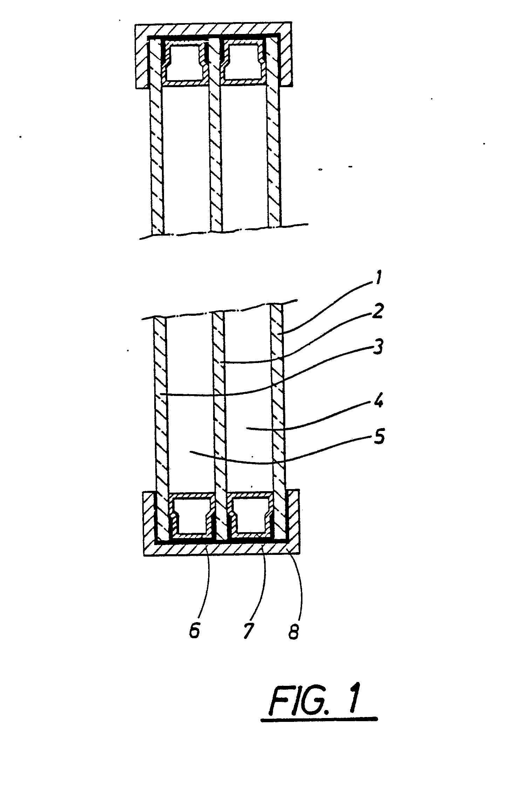

A window insert is illustrated in Figure 1. This may be of a previously disclosed type, and the Figure also shows such an insert of which the essential construction is already familiar. The insert exhibits in the case illustrated three window panes 1, 2 and 3 between which are formed two spaces 4 and 5. The spaces 4 and 5 are hermetically sealed by bonding edging strips 6 and 7 between the panes 1, 2 and 3. Also bonded in position is a reinforcing frame 8. The frames 6 and 7 may contain a moisture-absorbing substance for the purpose of preventing the formation of condensation in the spaces 4 and 5.

Inserts of this kind are usually executed with rectangular frames so as to produce a parallelepipedic insert. If it is to be used as a window, the insert may be set directly into a facade or, more usually, into an opening or non-opening window frame by means of which it may be set into a wall.

The reason for executing a window in this way is that it will provide a number of spaces which are independent of each other, in so doing restricting thermal transmission by convection, but without having to clean more than two glass surfaces. The spaces are, in fact, gas-filled as a general rule, as the result of which thermal transmission by convection will occur because the technical problems associated with spaces under vacuum, being principally the high pressure stresses on the panes of glass and the risk of dirty and moist atmospheric air leaking in, cannot be overcome at reasonable cost. A window insert of this kind provides a certain amount of thermal insulation through its aforementioned convection-limiting ability and because the air contained inside it is a poor thermal conductor. The transmission of radiation, on the other hand, is affected to an extremely insignificant degree, in particular with regard to the most short-wave form of radiation. This is to a certain extent a desirable feature of windows, because such windows are used in order to permit visible light to be admitted, although it is also a disadvantage because of the resulting passage of thermal radiation. The result is a steep rise in the temperature inside a building through solar radiation, or a major loss of energy through thermal radiation.

The invention may thus be applied to window inserts of the type described with regard to the fixed parts, these being the window panes and the frame. The invention can also be applied in conjunction with other types of element consisting of elements with internal spaces capable of being penetrated by radiation. The invention may thus be used not only for windows, but also for screens and walls affording protection against radiation or for containers enclosing, for example, equipment which gives off or is intended to afford protection against electromagnetic radiation. In the case of the elements in sheet form which are capable of being penetrated by radiation, it is possible to make use here of opaque glass, plastic or crystalline material instead of window glass, and instead of being in the form of flat sheets, the elements can also be executed in this case in the form of curved sheets, cylinders, spheres or other shapes. At least two elements must be present so as to provide an interjacent space which, as has already been mentioned, must be hermetically sealed.

The invention finds an important application in conjunction with elements which are capable of being penetrated by radiation and especially by light. The advantage that the gases are able, if selected appropriately, to absorb heat—but not light rays—can be utilized in the case of such elements. An additional effect is that the gases are reached by the radiation directly. Elements which cannot be penetrated, for example metal plates, can also be used. These will heat up in the presence of radiation and will then emit thermal radiation, the transmission of which through the element will be restricted by the gases in the manner described.

The characteristic feature of the invention is that said space between the elements, being in the case of the insert shown in Figure 1 at least one of the spaces 4 or 5, is filled with one or more gases selected specifically in order to provide a high degree of radiation absorption within the waveband within which it is wished that the transmission of radiation should not occur. The gas or gases used in windows for this purpose is/are thus selected in such a way that the visible radiation remains essentially unaffected, whereas the thermal radiation is restricted. It has been demonstrated in connection with the invention that it is possible to achieve a high degree of radiation absorption within a desired waveband by the appropriate selection of a gas or, as a rule, a number of gases which interact with each other. Each of the gases will usually exhibit absorption characteristics within a waveband which is narrower than that within which it is wished that absorption should occur. However, at least the major proportion of the desired waveband can be covered by a mixture of different gases with different absorption characteristics.

Examples of suitable gases are carbon monoxide, carbon dioxide and phosphorus trifluoride. These gases are entirely transparent, that is to say they do not absorb radiation within the visible range (solar radiation). They exhibit lower thermal conductivity than air, which is an advantage in this context. Furthermore, they also possess the desired characteristic of intense absorption of radiation within the 2—25 micrometer waveband. It is within this range that the major proportion of thermal radiation is found to occur. Thus, in the case of window applications, the benefit achieved is that the level of heat loss from the inside outwards will be reduced considerably during the heating-up period because long-wave thermal radiation will be restricted by absorption. The absorption phenomenon will cause the gas molecules to be agitated over a very short period, and re-transmission in the form of the emission of the energy received will take place immediately. This emission takes place to a large part in the direction from which the radiation originally arrived. A certain increase in the temperature of the gas may be expected to occur, however, with the result that the window will not feel cool to the touch from the inside.

It is possible by agitating the gas molecules to cause the emission of the energy received to take place in any desired direction. It would thus be reasonable to expect that the energy returned in the direction of the source of radiation will account for only a small proportion, and in any case for not more than one half of the energy received. However, it has been demonstrated in connection with the invention that the major proportion of the energy received is returned. The process involved is not fully appreciated, although emission appears to take place principally in the same direction from which the molecules received the radiation, in addition to which a mechanism has been identified whereby the radiation is received essentially by those molecules which are situated in the layer closest to the source of radiation, and in those instances in which emission takes place in a direction away from the source of radiation, close layers of molecules will be agitated and these in turn will emit radiation essentially in the direction of the source of radiation.

As far as concerns the characterizing principle of the invention to the effect that radiation is absorbed in a mass of gas of appropriate composition, such absorption is able to take place in a single layer, and from this point of view the absorbing element need only be executed with a single space. It may be desirable in certain cases, however, to provide the element with different characteristics in respect of the radiation reaching it from both sides. In cases such as these it may be appropriate to execute the element with at least two spaces. It may also be wished to impart other functions to the element, such as the restriction of thermal transmission by convection. This requires the space between the two outer surfaces of the element to be divided up into a number of layers, being two, three or more in number. It is not necessary for this purpose for all the spaces to contain the specified mixture of gases. On the other hand the separate spaces need not be hermetically sealed in relation to each other if the gas mixture is identical in those spaces which possess a certain amount of communication with each other. Any such communication must be restricted, however, in order to ensure that the best barrier to convection can be achieved.

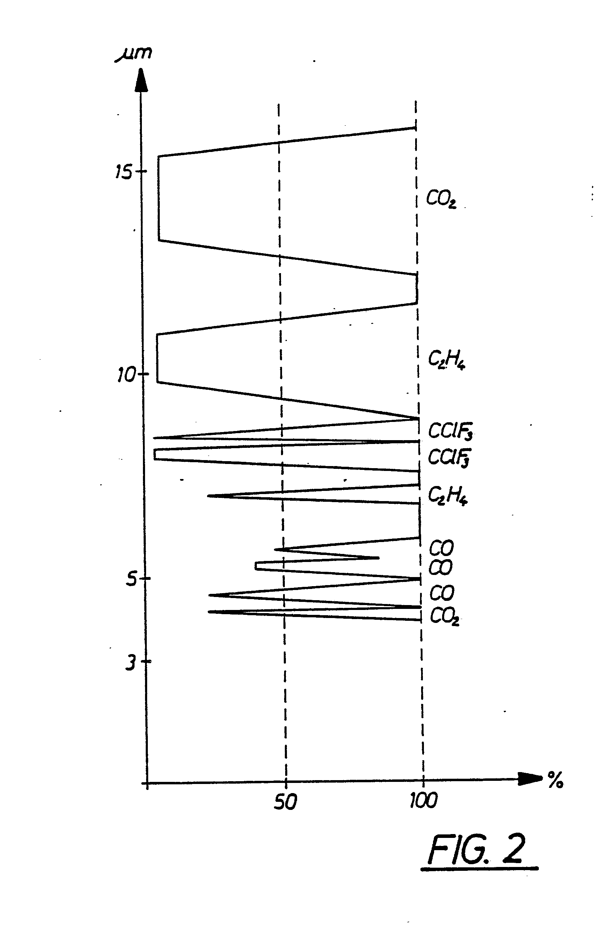

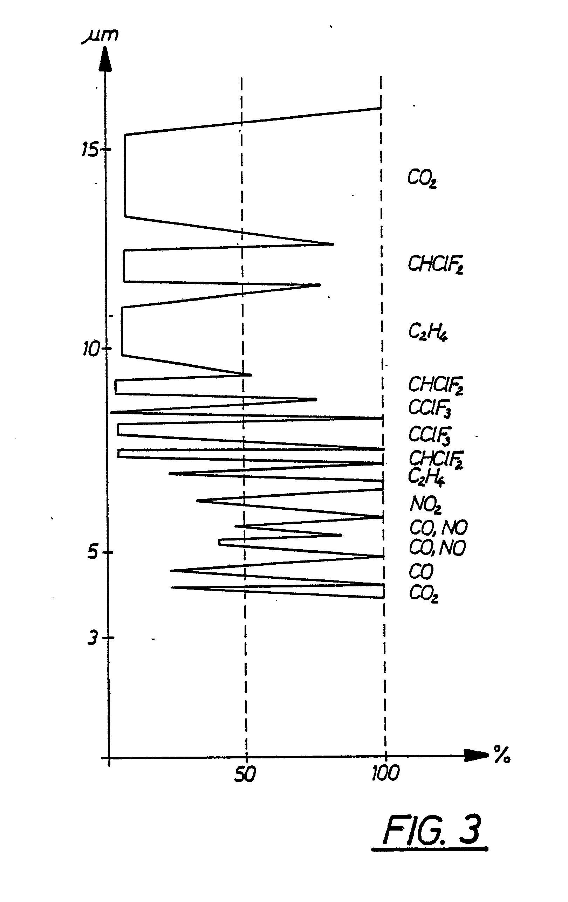

The selection of the gases is of critical significance to the invention. In the graphs in Figures 2 and 3 are plotted the curves for the permeability of a number of gases indicated in the figures by means of their chemical formulae. It is clear that considerable absorption of up to about 95% has been achieved within a large part of the waveband from approximately 4—16 micrometers, this being the waveband within which the main thermal radiation is situated. The x-axis in the figures shows the degree of permeability as a percentage value. The distance remaining along this axis thus indicates the permeability. Along the y-axis is shown the radiation wavelength in micrometers.

Figure 3 illustrates a different gas composition, which is also included in the figure and which also achieves an even denser absorption cover within said waveband. As may be appreciated from the figures, most of the gases exhibit a number of absorption areas.

Although the gases which are suitable for the absorption of thermal radiation are shown in Figures 2 and 3, the most important such gases are listed below.

| | |
|---|---|
| Carbon monoxide | $CO$ |
| Carbon dioxide | $CO_2$ |
| Nitric oxide | $NO$ |
| Nitrogen dioxide | $NO_2$ |
| Ethylene | $C_2H_4$ |
| Freon 13 | $CClF_3$ |
| Freon 22 | $CHClF_2$ |

What is important is that those substances which are used should possess a boiling point well below the area of application of the insulating element in question. Of the aforementioned gases, the highest boiling point is −78°C ($CO_2$). A low thermal conductivity will be found to be advantageous. Freon occupies an important position amongst the suitable gases.

The invention has been described with particular reference to windows, which is likely to be an important area of application.

It has also been stated that the invention is applicable to other structural elements such as walls, roofs and floors. The invention can also be applied to vessels and equipment containers such as vacuum flasks, hot-water heaters, ovens, cookers, cooking vessels, process vessels, tanks, heat exchangers, chimneys, gas containers, refrigerators and pipelines for liquids and gases.

The arrangement can also be used with advantage for holes in the double-skinned walls of boats, ships and aeroplanes for the purpose, amongst other things, of reducing the risk of condensation attributable to cold surfaces.

## Claims

1. Arrangement for restricting the transmission of electromagnetic radiation within a predetermined waveband, the arrangement comprising elements (1—3) in a light-transmitting material such as glass intended to be placed in the path of the radiation and which are positioned one after the other along that path, as well as enclosing in one or more spaces (4, 5) between them gases characterized in that a number of different gases is used, said gases being selected with regard to their absorption capacity within one or more wavebands in such a way that they will essentially cover the pre-determined waveband when used in combination with each other, said pre-determined waveband being essentially within the waveband from 2 to 25 micrometers, so that the transmission of thermal radiation is restricted while visible light is allowed to pass through.

2. Arrangement in accordance with Claim 1, characterized in that it is executed in the form of a window insert which may be of a previously disclosed type and which comprises at least two window panes (1—3) or similar combined together by means of a frame element (6—8) in such a way that at least one hermetically sealed space (4, 5) is formed between the panes, with at least one of the spaces containing said gases, which are selected so as to absorb the electromagnetic radiation within said pre-determined waveband.

3. Arrangement in accordance with Claim 1 or 2, characterized in that spaces (4, 5) bounded by the elements (1—3) are several in number, with at least one of the spaces containing the gases selected for the absorption of the electromagnetic radiation within the pre-determined waveband, whilst any remaining spaces can contain other gases, by means of which division into a number of spaces the transmission of heat by convection

0 163 639

can be restricted by the gases contained in the spaces.

4. Arrangement in accordance with any of the preceding Claims and intended for the absorption of long-wave thermal radiation essentially in the range 4—16 micrometers, characterized by a mixture of gases with their absorption band at least substantially covering said range.

## Patentansprüche

1. Anordnung zur Begrenzung der Übertragung einer elektromagnetischen Strahlung innerhalb eines vorbestimmten Wellenbandes, mit Elementen (1 bis 3) aus einem lichtdurchlässigen Material, wie Glas, die in dem Strahlenweg angeordnet sind und entlang diesem Strahlungsweg hintereinander liegen und die in einem oder mehreren Räumen (4, 5) zwischen sich Gase enthalten, dadurch gekennzeichnet, dass eine Anzahl verschiedener Gase verwendet ist, wobei diese Gase im Hinblick auf ihre Absorptionskapazität in einem oder mehreren Wellenbändern so ausgewählt sind, dass sie in Kombination miteinander im wesentlichen das vorbestimmte Wallenband umfassen, wobei dieses vorbestimmte Wellenband im wesentlichen innerhalb des Wellenbandes von 2 bis 25 um liegt, so dass die Übertragung von Wärmestrahlung begrenzt ist, während sichtbares Licht hindurchtreten kann.

2. Anordnung nach Anspruch 1, dadurch gekennzeichnet, dass sie in Form eines Fenstereinsatzes ausgeführt ist, der vorbekannter Art sein kann und der wenigstens zwei Fensterscheiben (1—3) oder dergleichen enthält, die mit Hilfe eines Rahmenelements (6—8) so miteinander vereinigt sind, dass wenigstens ein hermetisch abgedichteter Raum (4, 5) zwischen den Scheiben gebildet ist, wobei wenigstens einer der Räume die Gase enthält, die so ausgewählt sind, dass sie die elektromagnetische Strahlung innerhalb des vorbestimmten Wellenbandes absorbieren.

3. Anordnung nach Anspruch 1 oder 2, dadurch gekennzeichnet, dass mehrere durch die Elemente (1—3) begrenzte Räume (4, 5) vorgesehen sind, von denen wenigstens einer die für die Absorption der elektromangetischen Strahlung innerhalb des vorbestimmten Wellenbandes ausgewählten Gase enthält, während die verbleibenden Räume andere Gase enthalten können, wobei durch diese Unterteilung in mehrere Räume die Wärmeübertragung durch Konvektion durch die in ihnen enthaltenen Gase begrenzt werden kann.

4. Anordnung nach einem oder mehreren der vorhergehenden Ansprüche, die für die Absorption einer langwelligen Wärmestrahlung, im wesentlichen in Bereich von 4 bis 16 um bestimmt ist, gekennzeichnet durch eine Mischung von Gasen, deren Absorptionsband zumindest im wesentlichen diesen Bereich umfasst.

## Revendications

1. Dispositif pour limiter la transmission du rayonnement électromagnétique dans une gamme de longueurs d'onde prédéterminée, ledit dispositif comprenant des éléments (1—3) en un matérieur transmettant la lumière, tel que le verre, destinés à être placés sur le trajet du rayonnement, lesdits éléments étant positionnés les uns après les autres le long dudit trajet et enfermant également entre eux, dans un ou plusieurs espaces (4, 5), des gaz, caractérisé en ce qu'un certain nombre de gaz différents est utilisé, lesdits gaz étant choisis selon leur capacité d'absorption dans une ou plusieurs gammes de longueurs d'onde de manière telle qu'ils couvrent essentiellement la gamme de longueurs d'onde prédéterminée lorsqu'ils sont utilisés en combinaison les uns avec les autres, ladite gamme de longueurs d'onde prédéterminée étant essentiellement comprise entre 2 et 25 micromètres, de sorte que la transmission du rayonnement thermique est limitée, tandis que la lumière visible peut les traverser.

2. Dispositif selon la revendication 1, caractérisé en ce qu'il est réalisé sous la forme d'une fenêtre rapportée qui peut être du type décrit antérieurement et qui comprend au moins deux vitres de fenêtre (1—3) ou similaires, combinées ensemble à l'aide d'un élément de châssis (6—8) de manière telle qu'il se forme au moins un espace scellé hermétiquement (4, 5) entre les vitres, l'un au moins de ces espaces contenant lesdits gaz, qui son choisis pour absorber les rayonnements électromagnétiques dans ladite gamme de longueurs d'onde prédéterminée.

3. Dispositif selon la revendication 1 ou 2, caractérisé en ce que les espaces (4, 5) limités par les éléments (1—3) sont nombreux, l'un au moins de ces espaces contenant les gaz choisis pour l'absorption du rayonnement électromagnétique dans la gamme de longueurs d'onde prédéterminée, alors que les espaces restant peuvent contenir d'autres gaz et, grâce à cette division en un certain nombre d'espaces, la transmission de la chaleur par convection peut être limitée par les gaz contenus dans les espaces.

4. Dispositif selon l'une quelconque des revendications précédentes et destiné à l'absorption d'un rayonnement thermique à grandes longueurs d'onde essentiellement dans l'intervalle de 4—16 micromètres, caractérisé par un mélange de gaz dont la gamme d'absorption couvre au moins substantiellment ledit intervalle.

0  163  639

FIG. 1

1

*FIG. 2*

FIG. 3